# DEMANDE DE BREVET EUROPEEN

(11) **EP 4 772 322 A1**
(43) Date de publication de la demande: **08.07.2026**
(21) Numéro de dépôt: 25209867.8
(22) Date de dépôt: 05.09.2022
(51) Int. Cl.: B29B 17/02, H10F 19/80

(54) **PROCÉDÉ ET INSTALLATION DE TRAITEMENT POUR RECYCLAGE D'UN MODULE PHOTOVOLTAÏQUE**

(30) Priorité: 04.10.2021 FR 2110481
(62) Demande divisionnaire de: 22193950.7
(71) Demandeur: Commissariat à l'Energie Atomique et aux Energies Alternatives, 75015 Paris (FR)
(72) Inventeur: COUSTIER, Fabrice, 38054 GRENOBLE CEDEX 09 (FR); RIVA, Roland, 38054 GRENOBLE CEDEX 09 (FR)
(74) Mandataire: INNOV-GROUP

(57) **Abrégé**

L'invention concerne un procédé de traitement pour recyclage d'un module photovoltaïque (M), ledit module photovoltaïque (M) comprenant ;
- Une première couche (1) en face arrière du module photovoltaïque (M), cette première couche étant réalisée à base d'au moins un matériau polymère,
- Une deuxième couche (2), dite couche intermédiaire, comprenant une enveloppe d'encapsulation (21) dans laquelle sont placées des cellules photovoltaïques (20),
- Une troisième couche (3) formant un deuxième élément de protection en face avant du module photovoltaïque (M),
- Le procédé comportant :
- Une première étape d'usinage (E2) de la première couche du module photovoltaïque, configurée pour enlever la matière formant ledit premier élément de protection,
- Une deuxième étape d'usinage (E3, E3') de ladite couche intermédiaire, configurée pour enlever la matière formant l'enveloppe d'encapsulation (21) et/ou la matière formant lesdites cellules photovoltaïques (20).

## Description

### Domaine technique de l'invention

La présente invention se rapporte à un procédé de traitement pour recyclage d'un module photovoltaïque ainsi qu'à une installation de traitement pour recyclage d'un module photovoltaïque.

### Etat de la technique

Un module photovoltaïque comporte des cellules photovoltaïques destinées à convertir une énergie solaire en une énergie électrique.

Un tel module photovoltaïque comporte de nombreux matériaux intéressants à récupérer et à valoriser, lorsque le module est en fin de vie ou défaillant.

Classiquement, un module photovoltaïque se présente sous la forme d'un panneau composé par l'assemblage de trois couches superposées et fixées entre elles :
- Une première couche (appelée "backsheet") formant un premier élément de protection en face arrière ;
- Une deuxième couche, dite couche intermédiaire ; cette couche intermédiaire comporte les cellules photovoltaïques, la connectique électrique entre les cellules et une enveloppe d'encapsulation arrangée autour des cellules photovoltaïques ;
- Une troisième couche formant un deuxième élément de protection en face avant ; cette troisième couche peut être en verre pour être traversée par les rayons lumineux captés ;

En vue du recyclage d'un module photovoltaïque, différentes solutions ont déjà été envisagées. Une première méthode consiste à broyer le module dans sa totalité, puis de lui faire subir divers traitements thermiques et/ou chimiques afin de séparer les matériaux qui entrent dans sa composition, comme le verre, l'argent, le cuivre, le silicium... Cette première méthode est cependant coûteuse en énergie et peu respectueuse de l'environnement.

La demande de brevet WO2019/043329A1 propose une méthode de désassemblage d'un module photovoltaïque, qui consiste à retirer chaque couche du module pour la séparer, en la découpant avec un fil abrasif. Chaque couche retirée peut ensuite être traitée de manière séparée en vue de récupérer les matériaux d'intérêt. Cette dernière méthode présente certains inconvénients. Elle nécessite plusieurs postes de traitement distincts, d'abord pour la découpe, puis pour le broyage de chaque couche retirée.

La demande de brevet EP3352227A1 et la demande de brevet US2018/133720A1 décrivent des solutions de désassemblage de module photovoltaïque.

Le but de l'invention est de proposer un procédé de traitement pour recyclage d'un module photovoltaïque qui soit :
- Facile à mettre en œuvre, ne nécessitant que peu d'étapes de traitement ;
- Efficace en durée ;
- Adapté pour facilement récupérer les différents matériaux d'intérêt ;

### Exposé de l'invention

Ce but est atteint par un procédé de traitement pour recyclage d'un module photovoltaïque, ledit procédé étant tel que défini dans la revendication 1.

Des particularités du procédé sont définies dans les revendications dépendantes.

L'invention concerne également une installation de traitement pour recyclage d'un module photovoltaïque, l'installation étant telle que définie dans la revendication 5. Des particularités de l'installation sont définies dans les revendications dépendantes.

Il faut noter que contrairement à l'état de l'art, les opérations d'usinage ne sont pas ici mises en œuvre pour mettre un objet aux cotes désirées, ni pour lui donner une forme particulière mais pour récolter des matériaux d'intérêt avec des rendements élevés de manière à les valoriser.

Les copeaux obtenus, habituellement considérés comme des rebus/déchets, sont ici une source de matériaux d'intérêt. L'objectif de cette invention est de permettre un recyclage, ou d'offrir une deuxième vie aux matériaux qui constituent un module photovoltaïque. Cette invention permettra à ces différents matériaux d'être traités séparément et revalorisés :
- Le verre solaire formant la troisième couche pourra être réinjecté dans la fabrication de modules photovoltaïques ou utilisé pour d'autres applications ;
- Les composés fluorés contenus dans la première couche pourront être traités dans une filière spécialisée ;
- Les métaux et matériaux contenus dans la deuxième couche (silicium des cellules, argent, aluminium, indium, cuivre et étain utilisés pour les connexions électriques...) pourront être récupérés et recyclés ;
- Le matériau d'encapsulation des cellules (par exemple l'EVA) peut être réutilisé dans la fabrication de produits tels que tapis de sol, semelles de chaussures...

### Brève description des figures

D'autres caractéristiques et avantages vont apparaître dans la description détaillée qui suit, faite en liaison avec les figures annexées et listées ci-dessous :
- La figure 1 représente, vue en perspective, l'architecture multicouches d'un module photovoltaïque ;
- La figure 2 représente, vue en coupe, l'architecture multicouches d'un module photovoltaïque ;
- La figure 3 représente de manière schématique l'installation de traitement pour recyclage, selon l'invention ;
- La figure 4 représente un diagramme montrant les étapes du procédé de l'invention et ses différentes variantes.
- La figure 5 illustre la deuxième étape du procédé de l'invention, selon deux variantes de réalisation ;
- La figure 6 illustre la troisième étape du procédé de l'invention ;
- La figure 7 illustre la troisième étape du procédé de l'invention, selon une autre variante de réalisation ;

### Description détaillée d'au moins un mode de réalisation

Dans la suite de la description, la face avant du module photovoltaïque M correspond à une face du module recevant les rayons lumineux et la face arrière correspond à la face opposée à la face avant.

Dans la suite de la description, chaque couche du module photovoltaïque présente deux faces opposées, une première face orientée vers l'arrière et une deuxième face orientée vers l'avant.

Ci-après, par "élément de protection", on entend un élément pouvant présenter une fonction de rigidification et/ou une fonction de protection de surface.

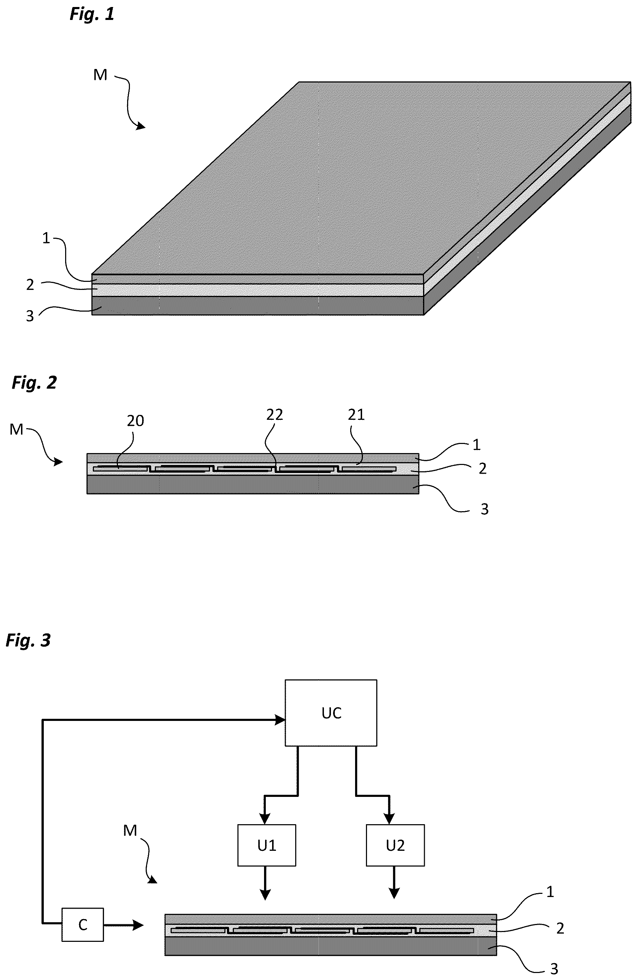

En référence à la figure 1 et à la figure 2, de manière connue, un module photovoltaïque comporte plusieurs couches superposées et assemblées entre elles :
- Une première couche 1 (appelée couramment "backsheet") formant un premier élément de protection en face arrière ; cette première couche est habituellement réalisée dans un matériau de type polymère;
- Une deuxième couche 2, dite couche intermédiaire, intercalée entre la première couche et la troisième couche (décrite ci-dessous), permettant l'assemblage d'un côté de la première couche et de l'autre côté de la troisième couche ; cette couche intermédiaire comporte les cellules photovoltaïques 20, la connectique électrique 22 et une enveloppe d'encapsulation 21 arrangée autour des cellules photovoltaïques ;
- Une troisième couche 3 formant un deuxième élément de protection en face avant ; cette troisième couche 3 est habituellement en verre ;

Il faut noter que sur les figures annexées, le module photovoltaïque M est représenté retourné, de sorte que sa face arrière est située au-dessus et la face avant est située au-dessous.

Pour des soucis de lisibilité sur les figures annexées, les différentes couches du module ne sont pas représentées à l'échelle. A titre d'exemple, la première couche 1 peut présenter une épaisseur de quelques centaines de µm (par exemple environ 350µm), la deuxième couche 2 peut présenter une épaisseur pouvant aller jusqu'à 1mm et la troisième couche 3 peut présenter une épaisseur d'environ 3 à 4mm.

La première couche 1 peut notamment assurer une fonction d'imperméabilité aux gaz et à l'eau, une fonction de protection/isolation électrique et une fonction de protection mécanique. Cette première couche 1 peut être réalisée à base d'un polymère fluoré. Il peut s'agir du polyfluorure de vinyle (PVF), par exemple commercialisé sous le nom TEDLAR (marque déposée) par la société DuPont (marque déposée).

De manière non limitative, la première couche 1 peut elle-même être composée d'un empilement de plusieurs strates : une strate de PVF, une strate en PET (poly(téréphtalate) d'éthylène), une strate de PVF.

Dans la couche intermédiaire 2, l'enveloppe d'encapsulation 21 est classiquement réalisée dans un polymère tel que de l'EVA (Ethylène-Acétate de Vinyl) formant un matériau sur lequel peuvent adhérer la première couche 1 d'un côté et la troisième couche 3 de l'autre côté et permettre l'assemblage des trois couches entre elles. Les trois couches peuvent être assemblées entre elles par laminage à chaud, de sorte que la première couche et la troisième couche viennent adhérer au matériau de l'enveloppe d'encapsulation, formant ainsi un empilement monobloc.

Dans la couche intermédiaire 2, les cellules photovoltaïques 20 sont connectées entre elles, en série/parallèle, formant plusieurs chaînes ("string" en anglais) de cellules. Des éléments de connexion électrique 22, par exemple en cuivre, permettent d'assurer les liaisons électriques entre les cellules 20 dans chaque chaîne.

Le module photovoltaïque M peut comporter un cadre (non représenté), par exemple en aluminium, agencé en périphérie de l'empilement pour rigidifier le module M. Pour la mise en œuvre de l'invention décrite ci-dessous, ce cadre, ainsi que la boîte de jonction électrique (non représentée) généralement fixée sur la face arrière du module M, sont préalablement retirés. Le procédé de l'invention est en effet dédié plus particulièrement au traitement de l'empilement de couches du module photovoltaïque M.

Comme indiqué ci-dessus, l'invention s'applique à un module photovoltaïque M dont la première couche 1 est formée d'un matériau facilement usinable, tel qu'un matériau de type polymère.

Le principe de l'invention consiste à venir usiner la première couche 1 d'abord et de collecter les copeaux 100 issus de cette première opération d'usinage puis d'usiner la deuxième couche 2 et de collecter les copeaux 200 issus de cette deuxième opération d'usinage. La troisième couche 3, par exemple en verre, peut ensuite être récupérée dans son intégralité.

Le procédé de traitement de l'invention est mis en œuvre à l'aide d'une installation de traitement adaptée.

En référence à la figure 3, l'installation de traitement conforme à l'invention comporte un premier poste d'usinage U1 dédié à l'usinage de la première couche 1 et un deuxième poste d'usinage U2 dédié à l'usinage de la deuxième couche 2. Elle comporte également une unité de traitement et de commande UC, chargée de contrôler les postes d'usinage en tenant compte de paramètres d'entrée et de données de mesure, par exemple fournies par des capteurs C. Cette unité de traitement et de commande UC est avantageusement un automate programmable doté de plusieurs modules d'entrées/sorties.

Pour la mise en œuvre du procédé de l'invention, le module photovoltaïque M à traiter est immobilisé à plat, par exemple en employant un adhésif, des brides mécaniques et/ou un système d'aspiration. Le module photovoltaïque est avantageusement retourné, de sorte que sa face arrière est rendue disponible pour l'usinage (comme sur les figures annexées).

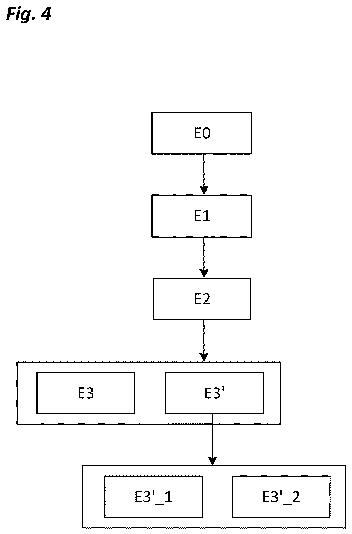

La figure 4 représente un diagramme reprenant les différentes étapes du procédé de l'invention et ses variantes possibles.

Selon un aspect particulier de l'invention, une étape initiale E0 du procédé consiste à caractériser le module photovoltaïque M à traiter. Cette caractérisation consiste principalement à déterminer les dimensions du module photovoltaïque M, c'est-à-dire par exemple et de manière non limitative :
- Epaisseur de la première couche 1,
- Epaisseur de la deuxième couche 2, au niveau des cellules photovoltaïque 20 et au niveau de l'enveloppe d'encapsulation 21,
- Avantageusement, densité/dureté des matériaux composant chaque couche,
- Avantageusement, dimensions des cellules photovoltaïques 20,
- Avantageusement, dimensions des éléments de connexion 22 en cuivre reliant les cellules,
- Avantageusement, épaisseur de la troisième couche 3,
- Avantageusement, positionnement des cellules photovoltaïque dans la deuxième couche.

Avantageusement, longueur et largeur du module photovoltaïque M. Certaines de ces données sont bien entendu optionnelles et sont acquises pour optimiser la mise en œuvre du procédé. C'est le cas par exemple de la densité/dureté des matériaux composant chaque couche, données qui sont utiles pour contrôler la vitesse d'usinage appliquée sur chaque poste d'usinage U1, U2, dans le but final de maintenir notamment un couple moteur compatible à la motorisation installée.

Il faut noter que certains des paramètres listés ci-dessus peuvent être des données constructeur, mémorisées dans l'unité de traitement et de commande UC.

Lors d'une première étape E1, l'unité de traitement et de commande UC acquiert ainsi les données utiles à la caractérisation du module. Elles peuvent être saisies manuellement par un opérateur et/ou déterminées de manière automatique, en utilisant des capteurs C de l'installation, connectées sur des modules d'entrée de l'unité de traitement et de commande UC. Ces données d'épaisseur des couches et avantageusement de densité/dureté permettent à l'unité de traitement et de commande UC de commander chaque poste d'usinage U1, U2 de manière adaptée, de bien sélectionner les zones à usiner pour cibler les matériaux d'intérêt et usiner le maximum de matière, en minimisant les pertes. On va notamment pouvoir adapter la profondeur de passe d'usinage et la vitesse d'avance de l'outil dans la matière et de rotation de l'outil, en fonction de l'épaisseur de la couche traitée et de la densité/dureté du matériau la composant.

Pour optimiser l'usinage de la deuxième couche 2, il est également préférable de disposer des données sur la géométrie des cellules présentes dans cette couche.

De même la tête d'usinage et/ou la granulométrie de la bande abrasive employée peuvent être également adaptées.

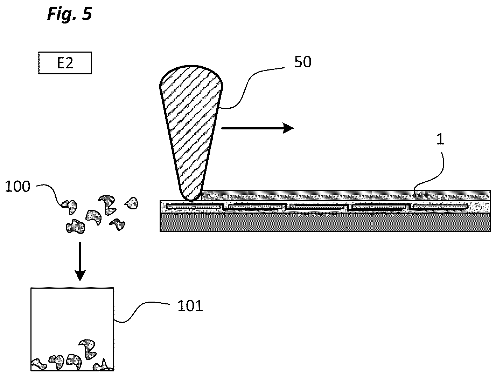

Une deuxième étape, représentée sur la figure 5, consiste en un premier usinage de la première couche 1.

Ce premier usinage est réalisé avec des premiers moyens d'usinage.

Dans une première réalisation illustrée par l'étape E2, les premiers moyens d'usinage peuvent comporter une bande abrasive 50 ou une meule, actionnée en rotation par un moteur pour venir retirer, à chaque passe, au moins une partie du matériau composant la première couche 1. Plusieurs passes successives sont avantageusement réalisées pour enlever toute la matière formant la première couche 1. La bande abrasive 50 ou la meule est amenée parallèlement à la surface de la première couche. Elle est commandée de manière à amener sa face de ponçage contre la surface de la première couche 1.

Les copeaux 100 issus de l'usinage de la première couche sont collectés dans des premiers moyens de collecte 101.

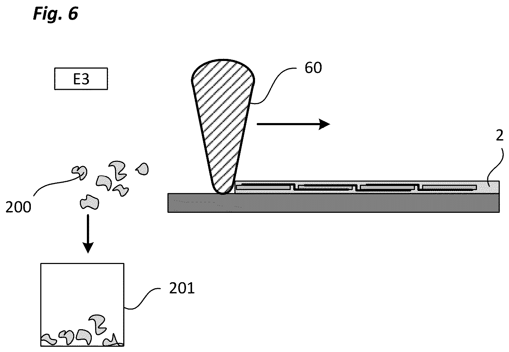

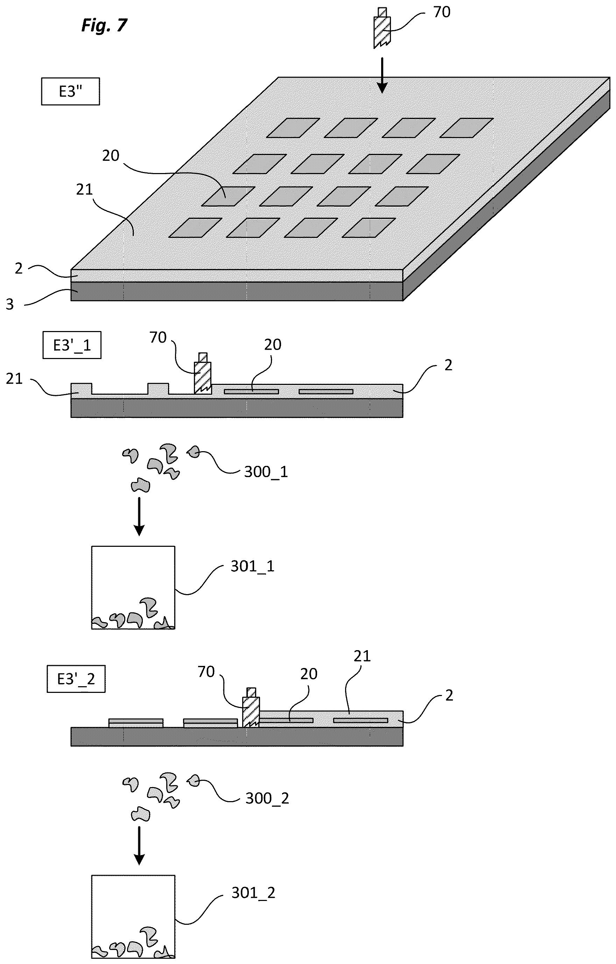

Une troisième étape, représentée sur la figure 6 et sur la figure 7, consiste en un deuxième usinage de la deuxième couche 2.

Cette troisième étape est mise en œuvre après la deuxième étape décrite ci-dessus. Elle est lancée lorsque la matière formant la première couche 1 est totalement retirée, afin d'éviter tout mélange entre les matériaux formant la première couche 1 et ceux formant la deuxième couche 2.

En pratique, on pourrait prévoir une étape intermédiaire, située entre la deuxième étape et la troisième étape, avec un usinage à faible profondeur de passe effectué à cheval sur les deux couches. Les poudres alors obtenues devraient alors être séparées des autres, pour traitement spécifique.

Selon les moyens d'usinage employés, l'usinage mis en œuvre lors de cette troisième étape permet de retirer la matière formant l'ensemble de la deuxième couche 2 et selon l'invention de sélectionner les zones à usiner pour réaliser un tri entre les matériaux formant l'enveloppe d'encapsulation 21 et les matériaux formant les cellules photovoltaïques 20.

Dans une première variante illustrée par l'étape E3, les moyens d'usinage peuvent être formés d'une bande abrasive 60 ou d'une meule, actionnée en rotation et commandée pour effectuer une ou plusieurs passes sur la deuxième couche 2 en vue de poncer la deuxième couche. La bande abrasive 60 ou la meule est amenée parallèlement à la surface de la deuxième couche 2. Elle est commandée de manière à amener sa face de ponçage contre la surface de la deuxième couche 2.

Dans cette première variante, les copeaux 200 obtenus sont un mélange des matériaux formant à la fois l'enveloppe d'encapsulation et les cellules photovoltaïques. Ils sont collectés dans des moyens de collecte 201 séparés des premiers moyens de collecte 101.

Dans une deuxième variante selon l'invention, illustrée par l'étape E3' sur la figure 7, les moyens d'usinage comportent une fraise 70 actionnable en rotation. La fraise 70 est commandée pour sélectionner les zones à usiner et permet de venir enlever la deuxième couche 2 de manière localisée.

Il est ainsi possible de venir usiner uniquement les zones occupées par les cellules photovoltaïques 20 (figure 7 - E3'_1) ou les zones occupées par l'enveloppe d'encapsulation 21 (figure 7 - E3'_2). On peut ainsi obtenir des copeaux 300_1 qui ne comportent que les matériaux formant les cellules photovoltaïques ou des copeaux 300_2 qui ne contiennent que les matériaux de l'enveloppe d'encapsulation.

La tête de la fraise 70 est amenée perpendiculairement à la surface de la deuxième couche 2 et est entraînée en rotation pour attaquer la matière, dans la zone ciblée.

Une fois que les matériaux de l'enveloppe d'encapsulation 21 ou des cellules photovoltaïques 20 ont été retirés et collectés, l'usinage peut se poursuivre pour terminer de retirer la deuxième couche 2. Pour chacune des deux variantes E3'_1 et E3'_2, les copeaux 300_1, 300_2 retirés sont collectés de manière séparée dans des deuxièmes moyens de collecte 301_1, 301_2.

Cet usinage peut être réalisé à l'aide de la même fraise 70 ou d'une autre fraise. Il serait également possible d'employer une bande abrasive ou un fil diamanté pour venir retirer les zones restantes et non encore usinées par le premier fraisage.

Il faut bien entendu considérer que chaque étape d'usinage est indépendante et peut être mise en œuvre selon l'une ou l'autre des variantes décrites ci-dessus. On peut ainsi imaginer faire le premier usinage avec un fil diamanté et un deuxième usinage avec la fraise, ou le premier usinage avec la bande abrasive et le deuxième usinage avec le fil diamanté. Toutes les combinaisons sont ainsi possibles.

Afin d'effectuer des usinages les plus précis possibles, il est nécessaire de déterminer préalablement la topologie du module photovoltaïque M.

De manière non limitative, à la fin de chaque étape d'usinage, l'unité de traitement et de commande UC peut être configurée pour assurer un nouveau contrôle des épaisseurs de chaque couche du module photovoltaïque M.

Dans une installation qui utilise une ou plusieurs bandes abrasives, la pression appliquée sur la bande ou sur la meule pour effectuer l'usinage se fera à l'aide de multiples rouleaux/sabots sur toute la largeur de la bande. Ainsi, l'épaisseur de matériau retirée sera identique malgré les irrégularités de topologie, et ce de façon à ce que chaque fraction de copeaux récoltée soit la plus pure possible. A titre d'exemple, on peut obtenir des copeaux composés à 95% du matériau retiré.

De manière avantageuse, les deux étapes d'usinage sont réalisées à sec, afin d'éviter toute dégradation des matériaux collectés, comme l'oxydation des métaux par exemple. Il faut noter que tout ce qui a été décrit ci-dessus pour le procédé de traitement de l'invention s'applique dans le cadre de l'installation de traitement et inversement. L'installation de traitement comporte les moyens matériels et logiciels pour la mise en œuvre du procédé de traitement.

Le procédé et l'installation conformes à l'invention sont particulièrement pertinents lorsqu'il s'agit de collecter les matériaux d'intérêt d'un module photovoltaïque **M,** en vue d'un recyclage. Après collecte de ces matériaux, il sera ainsi possible de :
- Réutiliser les plaques de verre pour la fabrication de nouveaux modules photovoltaïques ou du moins les réinjecter dans la filière de recyclage des verres plats ;
- Traiter les composés fluorés présents dans la première couche 1 de manière adéquate ;
- Récupérer et valoriser les matériaux utilisés pour les cellules photovoltaïques 20 et les éléments de connexion électrique comme le silicium, le cuivre, l'étain, l'indium, l'argent, l'aluminium...

## Revendications

1. Installation de traitement pour recyclage d'un module photovoltaïque (M), ledit module photovoltaïque comprenant plusieurs couches superposées formées de :
- Une première couche (1) formant un premier élément de protection en face arrière du module photovoltaïque (M),
- Une deuxième couche (2), dite couche intermédiaire, intercalée entre la première couche (1) et une troisième couche (3) et comprenant une enveloppe d'encapsulation (21) dans laquelle sont placées des cellules photovoltaïques (20),
- Ladite troisième couche (3) formant un deuxième élément de protection en face avant du module photovoltaïque,
- **Caractérisée en ce que** l'installation comporte :
- Une unité de traitement et de commande (UC) comportant des moyens d'acquisition des épaisseurs de la première couche et de la couche intermédiaire,
- Des premiers moyens d'usinage (U1) de la première couche du module photovoltaïque, commandés par l'unité de traitement et de commande (UC) et configurés pour enlever la matière formant ledit premier élément de protection,
- Des premiers moyens de collecte (101) des copeaux (100) obtenus par enlèvement de matière par les premiers moyens d'usinage,
- Des deuxièmes moyens d'usinage (U2) de ladite couche intermédiaire, commandés par l'unité de commande et de traitement (UC) et configurés pour enlever la matière formant l'enveloppe d'encapsulation et/ou la matière formant lesdites cellules photovoltaïques,
- Des deuxièmes moyens de collecte (201, 301_1, 301_2) des copeaux (200, 300_1, 300_2) obtenus par enlèvement de matière par les deuxièmes moyens d'usinage.

2. Installation selon la revendication 1, **caractérisée en ce que** les premiers moyens d'usinage (U1) et les deuxièmes moyens d'usinage (U2) sont distincts.

3. Installation selon l'une des revendications 1 ou 2, **caractérisée en ce que** les deuxièmes moyens de collecte (201, 301_1, 301_2) sont séparés des premiers moyens de collecte (101).

4. Installation selon l'une des revendications 1 à 3, **caractérisée en ce que** les premiers moyens d'usinage comportent une première bande abrasive (50), actionnée en rotation par un moteur pour venir retirer, à chaque passe, au moins une partie du matériau composant la première couche (1).

5. Installation selon l'une quelconque des revendications 1 à 4, **caractérisée en ce que** les deuxièmes moyens d'usinage sont formés d'une deuxième bande abrasive (60), actionnée en rotation et commandée pour effectuer une ou plusieurs passes sur la deuxième couche (2) en vue de poncer la deuxième couche.

6. Installation selon l'une quelconque des revendications 1 à 5, **caractérisée en ce que** l'unité de traitement et de commande (UC) est configurée pour contrôler les premiers moyens d'usinage et les deuxièmes moyens d'usinage en fonction des épaisseurs acquises pour la première couche et pour la couche intermédiaire.

7. Installation selon la revendication 6, **caractérisée en ce que** l'unité de traitement et de commande (UC) est configurée pour contrôler les premiers moyens d'usinage et les deuxièmes moyens d'usinage en fonction de la densité/dureté de la première couche et de la couche intermédiaire.

8. Procédé de traitement pour recyclage d'un module photovoltaïque (M), ledit module photovoltaïque (M) comprenant plusieurs couches superposées formées de :
- Une première couche (1) formant un premier élément de protection en face arrière du module photovoltaïque (M), cette première couche étant réalisée à base d'au moins un matériau polymère,
- Une deuxième couche (2), dite couche intermédiaire, intercalée entre la première couche (1) et une troisième couche (3) et comprenant une enveloppe d'encapsulation (21) dans laquelle sont placées des cellules photovoltaïques (20),
- La troisième couche (3) formant un deuxième élément de protection en face avant du module photovoltaïque (M),
- **Caractérisé en ce que** le procédé comporte :
- Une étape d'acquisition (E1) des épaisseurs de la première couche et de la couche intermédiaire mise en œuvre à l'aide d'une unité de traitement et de commande (UC),
- Une première étape d'usinage (E2) de la première couche du module photovoltaïque, configurée pour enlever la matière formant ledit premier élément de protection, à l'aide de premiers moyens d'usinage commandés par l'unité de traitement et de commande (UC),
- Une première étape de collecte des copeaux (100) obtenus par enlèvement de matière lors de la première étape d'usinage,
- Une deuxième étape d'usinage (E3, E3') de ladite couche intermédiaire, configurée pour enlever la matière formant l'enveloppe d'encapsulation (21) et/ou la matière formant lesdites cellules photovoltaïques (20), mise en œuvre à l'aide de seconds moyens d'usinage commandés par l'unité de traitement et de commande (UC),
- Une deuxième étape de collecte des copeaux (200, 300_1, 300_2) obtenus par enlèvement de matière lors de la deuxième étape d'usinage.

9. Procédé selon la revendication 8, **caractérisé en ce que** la première étape d'usinage et la deuxième étape d'usinage sont mises en œuvre sur des postes d'usinage distincts.

10. Procédé selon la revendication 8 ou 9, **caractérisé en ce que** la deuxième étape de collecte est mise en œuvre à l'aide de deuxièmes moyens de collecte (201, 301_1, 301_2) qui sont séparés des premiers moyens de collecte (101) utilisés pour collecter les copeaux de la première étape de collecte.

11. Procédé selon l'une quelconque des revendications 8 à 10, **caractérisé en ce que** le procédé comporte une étape intermédiaire, située entre la première étape d'usinage et la deuxième étape d'usinage, avec un usinage à faible profondeur de passe effectué à cheval sur les deux couches.

12. Procédé selon l'une quelconque des revendications 8 à 11, **caractérisé en ce que** la première étape d'usinage est mise en œuvre à l'aide d'une bande abrasive (50) actionnée en rotation par un moteur pour venir retirer, à chaque passe, au moins une partie du matériau composant la première couche (1).

13. Procédé selon l'une quelconque des revendications 8 à 12, **caractérisé en ce que** la deuxième étape d'usinage est mise en œuvre à l'aide d'une bande abrasive (60), actionnée en rotation et commandée pour effectuer une ou plusieurs passes sur la deuxième couche (2) en vue de poncer la deuxième couche.

14. Procédé selon l'une quelconque des revendications 8 à 13, **caractérisé en ce que** la première étape d'usinage et la deuxième étape d'usinage sont mises en œuvre en tenant compte des épaisseurs acquises pour la première couche et pour la couche intermédiaire.

15. Procédé selon l'une des revendications 8 à 14, **caractérisée en ce que** la première étape d'usinage et la deuxième étape d'usinage sont mises en œuvre en tenant compte de la densité/dureté de la première couche et de la couche intermédiaire.

16. Procédé selon l'une des revendications 8 à 15, **caractérisé en ce qu'**il comporte une étape de contrôle des épaisseurs de chaque couche du module photovoltaïque mise en œuvre après la première étape d'usinage et la deuxième étape d'usinage.
